# EUROPEAN PATENT APPLICATION

(11) **EP 2 061 092 A1**
(43) Date of publication of application: **20.05.2009**
(21) Application number: 08153692.2
(22) Date of filing: 31.03.2008
(51) Int. Cl.: H01L 31/052, G02B 6/00

(54) **Thin film planar solar concentrator/collector**

(30) Priority: 16.11.2007 US 941851
(71) Applicant: QUALCOMM MEMS Technologies, Inc., San Diego, CA 92121 (US)
(72) Inventor: Gruhlke, Russell Wayne, Milpitas, CA 95035 (US); Xu, Gang, Cupertino, CA 95014 (US); Mignard, Marc Maurice, San Jose, CA 95128 (US)
(74) Representative: Witte, Weller & Partner

(57) **Abstract**

In various embodiments described herein, a device comprising a light guiding layer (105) optically coupled to a photocell (100) is described. A plurality of surface features (108) are formed on one the surface of the light guiding layer. The surface features (108) can comprise facets that are angled with respect to each other. Light (112) incident on the surface of the light guide is redirected by the surface features and guided through the light guide by multiple total internal reflections. The guided light (112) is directed towards a photocell (100).

## Description

### BACKGROUND OF THE INVENTION

### Field of the Invention

The present invention relates to the field of light collectors and concentrators and more particularly to using micro-structured thin films to collect and concentrate solar radiation.

### Description of the Related Art

Solar energy is a renewable source of energy that can be converted into other forms of energy such as heat and electricity. Major drawbacks in using solar energy as a reliable source of renewable energy are low efficiency in converting light energy to heat or electricity and the variation in the solar energy depending on the time of the day and the month of the year.

A Photovoltaic (PV) cell based on the principle of converting light energy to electrical energy can be used to convert solar energy to electrical energy. Systems using PV cells can have conversion efficiencies between 10-20%. PV cells can be made very thin and are not big and bulky as other devices that use solar energy. PV cells can range in size from a few millimeters to 10's of centimeters. The individual electrical output from one PV cell may range from a few milliWatts to a few Watts. Several PV cells may be connected electrically and packaged to produce a sufficient amount of electricity.

Solar concentrators can be used to collect and focus solar energy to achieve higher conversion efficiency in PV cells. For example, parabolic mirrors can be used to collect and focus light on a device that converts light energy in to heat and electricity. Other types of lenses and mirrors can also be used to significantly increase the conversion efficiency but they do not overcome the variation in amount of solar energy received depending on time of the day, month of the year or weather conditions. Further the systems employing lenses/mirrors tend to be bulky and heavy because the lenses and mirrors that are required to efficiently collect and focus sunlight have to be large.

PV cells can be used in wide range of applications such as providing power to satellites and space shuttles, providing electricity to residential and commercial properties, charging automobile batteries and other navigation instruments. The performance of the PV cell depends on sunlight thus the conversion efficiency of PV cells, similar to other devices using solar energy depends on the time of day, month of the year and daily weather conditions. To overcome these drawbacks it is advantageous to employ light collectors and concentrators that collect and focus light on the PV cell and track the movement of the sun through the day. Additionally it is also advantageous to have the ability to collect diffused light on cloudy days. Such systems are complicated, often bulky and large. For many applications it is also desirable that these light collectors and/or concentrators are compact in size.

### SUMMARY

Various embodiments described herein comprise light guides for collecting/concentrating ambient light and directing the collected light to a photocell. The light guide may include surface relief features to redirect incident light and propagate it through the light guide by multiple total internal reflections. The surface relief features may comprise facets that reflect light. In some embodiments, the facets may be angled with respect to each other. The photocell is optically coupled to the light guide. In some embodiments the photocell may be disposed adjacent to the light guide. In some other embodiments, the photocell may be disposed at one corner of the light guide. In yet other embodiments, the photocell may be disposed below the light guide. In some embodiments, the light guide may be disposed on a substrate. The substrate may comprise glass, plastic, electrochromic glass, smart glass, etc.

In one embodiment, a device for collecting solar energy is disclosed. The device comprises a first light guide having top and bottom surfaces, said light guide guiding light therein by multiple total internal reflections at said top and bottom surfaces. The device further comprises a photocell optically coupled to the first light guide. In some embodiments, a plurality of prismatic features is disposed on the first light guide to redirect ambient light received through said top surface such that said light is guided in the light guide by total internal reflection from said top and bottom surfaces to said photocell. In one embodiment, the prismatic features may comprise elongate grooves. In some embodiments, the elongate grooves may be straight. In other embodiments, the elongate grooves may be curved. In one embodiment of the device, the prismatic features may comprise pits. In one embodiment, the pits may be conical.

In one embodiment, the device may comprise a first light guide further comprising a prismatic film disposed over a substrate and said film including said plurality of prismatic features therein. In some embodiments, said prismatic features may be at said bottom surface of said first light guide. In some other embodiments, the prismatic features may extend along a plurality of parallel linear paths. In other embodiments, the prismatic features may extend along plurality of concentric circular curved paths. In yet other embodiments, the prismatic features extend along a plurality of elliptical curved paths.

In one embodiment of the device, the first light guide comprises a first layer comprising said first set of prismatic features; and a second layer comprising a second set of prismatic features. In some embodiments, at least some of the prismatic features in the first layer are laterally offset with respect to some of the prismatic features in the second layer. In another embodiment, at least some of the prismatic features in the first layer are shaped differently than some of the prismatic features in the second layer. In another embodiment of the device, a second light guide having top and bottom surfaces and including a plurality of edges between said top and bottom surfaces is disposed below the first light guide. The second light guide comprises a plurality of prismatic features to redirect light received through said bottom surface such that light is guided in the second light guide by total internal reflection from said top and bottom surfaces. The light that is guided in the second light guide is directed towards a photocell.

In one embodiment of the invention, a device for collecting solar energy is disclosed. The device comprises a first means for guiding light, said first means having first and second means for reflecting light , such that light is guided within said means for guiding light by multiple total internal reflections at said first and second light reflecting means. The device further comprises a means for converting light energy into alternate forms of energy; and a means for redirecting ambient light received through said first and second light reflecting means such that said light is guided in the means for guiding light by total internal reflection from said first and second light reflecting means to said means for converting light energy into electrical energy. In one embodiment, the first and second light reflecting means may comprise the top and bottom surface of the light guiding means. A plurality of edges may be disposed between the top and bottom surface of the light guiding means.

In one embodiment of the invention, a method of manufacturing a device for collecting solar energy is disclosed. The method comprises providing a first light guide, said first light guide having top and bottom surfaces. The method further comprises providing a photocell such that the first light guide is optically coupled to the photocell; and forming a plurality of prismatic features on one of the top or bottom surfaces of said first light guide.

In one embodiment, a device for collecting ambient light is disclosed. The device comprises a first means for guiding light; said first means having first and second means for reflecting light such that light is guided within said first light guiding means by multiple total internal reflections at said first and second light reflecting means; and a plurality of means for redirecting ambient light received through said top surface of the first light guiding means at a first angle greater than 45 degrees with respect to the normal to said first light guiding means, said redirecting means refracting said ambient light at a second angle such that light is guided in the first light guiding means by total internal reflection from said first and second light reflecting means.

### BRIEF DESCRIPTION OF THE DRAWINGS

Example embodiments disclosed herein are illustrated in the accompanying schematic drawings, which are for illustrative purposes only.

**Figure 1A** illustrates the side view of a prismatic light guide comprising a plurality of prismatic features to collect and guide light to a photo cell.

**Figure 1B** illustrates a perspective view of a prismatic light guide comprising a plurality of prismatic features to collect and guide light to a photovoltaic cell.

**Figure 1C** shows the perspective view of the embodiment described in **Figure 1A****.**

**Figure 2** illustrates an embodiment comprising two layers of prismatic light guides stacked with offsetting prismatic features to collect and guide light in to a photovoltaic cell with greater efficiency.

**Figure 3** illustrates the distribution of light rays incident on the light guide that are coupled into the guided modes.

**Figure 4** illustrates the lobe along which incident radiation is coupled into guided modes for a prismatic film with wide angled facets.

**Figure 5** illustrates the lobe along which incident radiation is coupled into guided modes for a prismatic film with narrow angled facets.

**Figure 6** illustrates an embodiment with two layers of prismatic light guides comprising narrow and wide angled facets for maximizing collection angle.

**Figure 7** illustrates an embodiment wherein the narrow and wide angled facets are comprised on the same prismatic light guide.

**Figure 8A** illustrates an embodiment comprising of prismatic features that are arranged concentrically with a photo cell placed at the center.

**Figure 8B** illustrates an embodiment comprising of curvilinear prismatic features and a photo cell placed at one edge.

**Figure 9** illustrates a matrix of microstructure patterns.

**Figure 10** illustrates an embodiment wherein the photocell is beveled with respect to the prismatic thin film

**Figure 11** illustrates the side view of an embodiment comprising a collector lens, a prismatic film and a reflector disposed over an array of photocells.

**Figure 12A** illustrates the top view of a thin film comprising conical features bound by reflectors on two sides to direct light in to two photocells placed at the other two edges.

**Figure 12B** is a side view of the embodiment illustrated in Figure 12A with conical facets.

**Figure 13A** illustrates the side view of an embodiment comprising two light collecting films and a photocell.

**Figure 13B** illustrates the side view of an embodiment comprising two light collecting films and two photocells.

**Figure 13C** illustrates the side view of an embodiment comprising one light collecting film and two photocells.

**Figure 14** shows light collecting plate, sheet or film optically coupled to photo cells placed on the roof and on the windows of a residential dwelling.

**Figure 15** shows an embodiment wherein light collecting plate, sheet or film optically coupled to photo cells is placed on the roof of an automobile.

**Figure 16** illustrates a light collecting plate, sheet or film optically coupled to photo cells is attached to the body of a laptop.

**Figure 17** shows an example of attaching light collecting plate, sheet or film optically coupled to photo cells is attached to an article of clothing.

**Figure 18** shows an example of placing light collecting plate, sheet or film optically coupled to photo cells on shoes.

**Figure 19** indicates an embodiment wherein light collecting plate, sheet or film optically coupled to photo cells is attached to the wings and windows of an airplane.

**Figure 20** indicates an embodiment wherein light collecting plate, sheet or film optically coupled to photo cells is attached to a sail boat.

**Figure 21** indicates an embodiment wherein light collecting sheet, plate or film optically coupled to photo cells is attached to a bicycle.

**Figure 22** indicates an embodiment wherein light collecting plate, sheet or film optically coupled to photo cells is attached to a satellite.

**Figure 23** shows an embodiment wherein light collect sheet that is substantially flexible to be rolled is optically coupled to photo cells.

### DETAILED DESCRIPTION OF THE PREFERRED EMBODIMENT

The following detailed description is directed to certain specific embodiments of the invention. However, the invention can be embodied in a multitude of different ways. As will be apparent from the following description, the embodiments may be implemented in any device that is configured to collect, trap and concentrate radiation for a source. More particularly, it is contemplated that the embodiments described herein may be implemented in or associated with a variety of applications such as providing power to residential and commercial properties, providing power to electronic devices such as laptops, PDAs, wrist watches, calculators, cell phones, camcorders, still and video cameras, mp3 players etc. In addition the embodiments described herein can be used in wearable power generating clothing, shoes and accessories. Some of the embodiments described herein can be used to charge automobile batteries, navigational instruments and pumping water. The embodiments described herein can also find use in aerospace and satellite applications.

In various embodiments described herein, a solar collector and/or concentrator is coupled to a photo cell. The solar collector and/or concentrator comprises a light guide; for example a plate, sheet or film; with prismatic turning features formed thereon. Ambient light that is incident on the light guide is turned into the light guide by the prismatic features and guided through the light guide by total internal reflection. A photo cell is disposed along one or more edges of the light guide and light that is emitted out of the light guide is coupled into the photo cell. Using the light guide to collect, concentrate and direct ambient light to photo cells may realize opto-electric devices that convert light energy into heat and electricity with increased efficiency and lower cost. The light guide may be formed as a plate, sheet or film. The light guide may be fabricated from a rigid or a semi-rigid material. In some embodiments, the light guide may be formed of a flexible material. In yet other embodiments, the light guide may comprise a thin film. The light guide may comprise grooves arranged in a linear fashion. In alternate embodiments, the prismatic features may have non-linear extent. For example, in some embodiments the prismatic features may be arranged along curves. An alternate embodiment may comprise of a thin film light guide with conical reflective features dispersed through the light guiding medium.

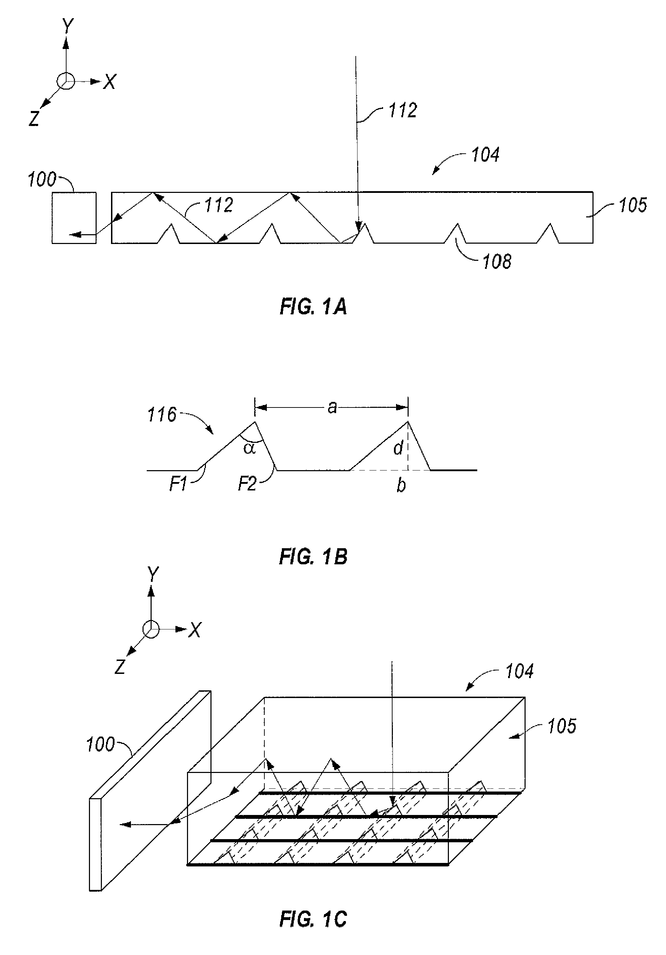

One embodiment of a prismatic light guide used to couple ambient light into a photo cell is shown in **Figure 1A****.** The photo cell may be a photovoltaic cell or a photo detector. The prismatic light guiding collector is based on the principle of reciprocity. **Figure 1A** illustrates the side view of an embodiment comprising a light guide 104 disposed with respect to a photo cell 100. In some embodiment, the light guide 104 may further comprise a substrate 105 and a plurality of prismatic features 108 disposed thereon. The light guide 104 may comprise a top and bottom surface including a plurality of edges therebetween. Light incident on the light guide may be redirected into the light guide by the plurality of prismatic features and guided within the light guide by multiple total internal reflections at the top and bottom surface. The light guide 104 may comprise optically transmissive material that is transparent to radiation at one or more wavelengths that the photo cell is sensitive to. For example in one embodiment, the light guide 104 may be transparent to wavelengths in the visible and near infra-red region. In other embodiments, the light guide 104 may be transparent to wavelengths in the ultra-violet or infra-red regions. The light guide 104 may be formed from rigid or semi-rigid material such as glass or acrylic so as to provide structural stability to the embodiment. Alternatively the light guide 104 may be formed of flexible material such as a flexible polymer.

The light guide 104 comprises two surfaces. The upper surface is configured to receive ambient light. The bottom surface is disposed below the upper surface. The light guide 104 is bounded by an edge all around. Typically, the length and width of the light guide 104 is substantially greater than the thickness of the light guide 104. The thickness of the light guide 104 may vary from 0.5 to 10 mm. The area of the light guide 104 may vary from 0.01 to 10000 cm². In some embodiments, the refractive index of the material comprising the light guide 104 may be significantly higher than the surrounding so as to guide a large portion of the ambient light within the light guide 104 by total internal reflection (TIR).

In one embodiment, as shown in **Figure 1A****,** the light guide comprises of prismatic features 108 disposed on the bottom surface of the substrate 105. The prismatic features in general are elongated grooves formed on the bottom surface of the substrate 105. The grooves may be filled with an optically transmissive material. The prismatic features 108 may be formed on the bottom surface of the substrate 105 by molding, embossing, etching or other alternate techniques. Alternatively the prismatic features 108 may be disposed on a film which may be laminated on the bottom surface of the substrate 105. In some embodiments comprising a prismatic film, light may be guided within the prismatic film alone. In such embodiments, the substrate 105 may provide structural stability alone. The prismatic features 108 may be comprise a variety of shapes. For example, the prismatic features 108 may be linear v-grooves. Alternately, the prismatic features 108 may comprise curvilinear grooves or non-linear shapes.

**Figure 1B** shows an enlarged view of prismatic features 108 in the form of a linear v-groove 116. The v-groove 116 comprises two planar facets F1 and F2 arranged with an angular separation α with respect to each other as shown in **Figure 1B****.** The angular separation α between the facets may vary from 15 degrees to 120 degrees. In some embodiments, the facets F1 and F2 may be of equal lengths. Alternatively in other embodiments, the length of one of the facets may be greater than the other. The distance between two consecutive v-grooves 'a' may vary between 0.01 to 0.5 mm. The width of the v-groove indicated by 'b' may vary between 0.001 to 0.100 mm while the depth of the v-groove indicated by 'd' may vary between 0.001 to 0.5 mm.

**Figure 1C** shows the perspective view of the embodiment described in **Figure 1A****.** As shown in **Figure 1C** the embodiment described in **Figure 1C** comprises of rows of linear v-grooves arranged along the bottom surface of the substrate 105.

Referring to **Figures 1A** and **1C****,** a photo cell 100 is disposed laterally with respect to the light guide 104. The photo cell is configured to receive light guided through the light guide 104 by the prismatic features 108. The photo cell 100 may comprise a single or a multiple layer p-n junction and may be formed of silicon, amorphous silicon or other semiconductor materials such as Cadmium telluride. In some embodiments, photo cell 100 based on photoelectrochemical cells, polymer or nanotechnology may be used. Photo cell 100 may also comprise thin multispectrum layers. The multispectrum layers may further comprise nanocrystals dispersed in polymers. Several multispectrum layers may be stacked to increase efficiency of the photo cell 100. **Figures 1A and 1B** show an embodiment wherein the photo cell 100 is disposed along one edge of the light guide 104 (for example, to the left of the light guide 104). However, another photo cell may be disposed at the other edge of the light guide 104 as well (for example, to the right of the light guide 104). Other configurations of positioning the photo cell with respect to the light guide 104 are also possible.

Ambient light that is incident on the upper surface of the light guide 104 is transmitted through the light guide 104 as indicated by the light path 112. Upon striking a facet of the prismatic feature 108, the light is total internally reflected by multiple reflections from the upper and bottom surface of the light guide 104. After striking the edge of the light guide 104, the ray of light exits the light guide 104 and is optically coupled to the photo cell 100. Lenses or light pipes may be used to optically couple light from the light guide 104 to the photo cell 100. In one embodiment, for example, the light guide 104 may be devoid of prismatic features 108 towards the end closer to the photo cell 100. The portion of the light guide 104 without any prismatic features may function as a light pipe. The amount of light that can be collected and guided through the light guide will depend on the geometry, type and density of the prismatic features. The amount of light collected will also depend upon the refractive index of the light guiding material, which determines the numerical aperture.

Light is guided through the light guide 104 by TIR. The guided light may suffer losses due to absorption in the light guide and scattering from other facets. To reduce this loss in the guided light, it is desirable to limit the length of the light guide 104 to tens of inches so as to reduce the number of reflections. However, limiting the length of the light guide 104 may reduce the area over which light is collected. Thus in some embodiments, the length of the light guide 104 may be increased to greater than tens of inches. In some other embodiments, optical coatings may be deposited on the surface of the light guide 104 to reduce Fresnel loss.

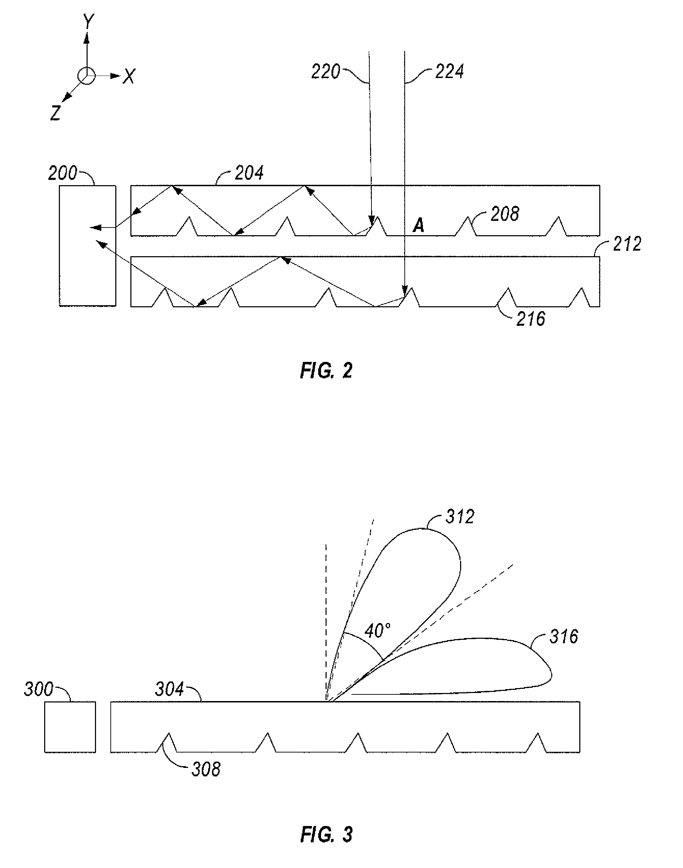

When the ray of light strikes the part of the light guide that is devoid of the prismatic feature 108, it can be transmitted through the light guide and not be turned into the light guide. To reduce the amount of light escaping the light guide in this manner, it may be advantageous to stack several light guide layers comprising prismatic features wherein the prismatic features are offset with respect to each other as illustrated in **Figure 2. Figure 2** illustrates an exemplary embodiment 2 comprising a first light guiding layer 204 with prismatic features 208 and a second light guiding layer 212 with prismatic features 216. A photo cell 200 is disposed laterally with respect to the two light guiding layers 204 and 212. The prismatic features 208 and 216 are offset with respect to each other. Light ray 220 is turned and guided through the light guide 204 as described above. Light ray 224 which passes through the light guide 204 from point A is turned and guided through the light guide 212. Offsetting the prismatic features 208 and 216 in this manner reduces the spaces between the features and increases the density of the prismatic features. Offsetting the features may increase the amount of light optically coupled to the photo cell thereby increasing the electrical output of the photo cell. Since the light guide layers 204 and 212 can be thin, it is possible to stack multiple light guide layers and increase the amount of light coupled to the PV cell. The number of layers that can be stacked together depends on the size and/or thickness of each layer and the Fresnel loss at the interface of each layer. In some embodiments, at least ten light guide layers may be stacked together.

An advantage of using a prismatic light guiding plate, sheet or film to collect, concentrate and direct light towards a photo cell is that lesser number of photo cells maybe needed to achieve the desired electrical output. Thus this technique may possibly reduce the cost of generating energy with photo cells.

**Figure 3** shows a distribution of light rays incident on the light guide that are coupled into the light guide by the prismatic features. The distribution of the incident light includes two lobes 312 and 316. Incident lobe 312 is close to the normal to the surface of the light guide. The incident lobe 312 can span from near normal incidence to the light guide 104 to approximately 45degrees from the normal to the light guide 104. Incident lobe 316 is oriented substantially parallel to the surface of the light guide. The angular spread of the incident lobe can range from approximately 45 degrees with respect to the surface of the light guide 104 to approximately grazing angles to the surface of the light guide 104.

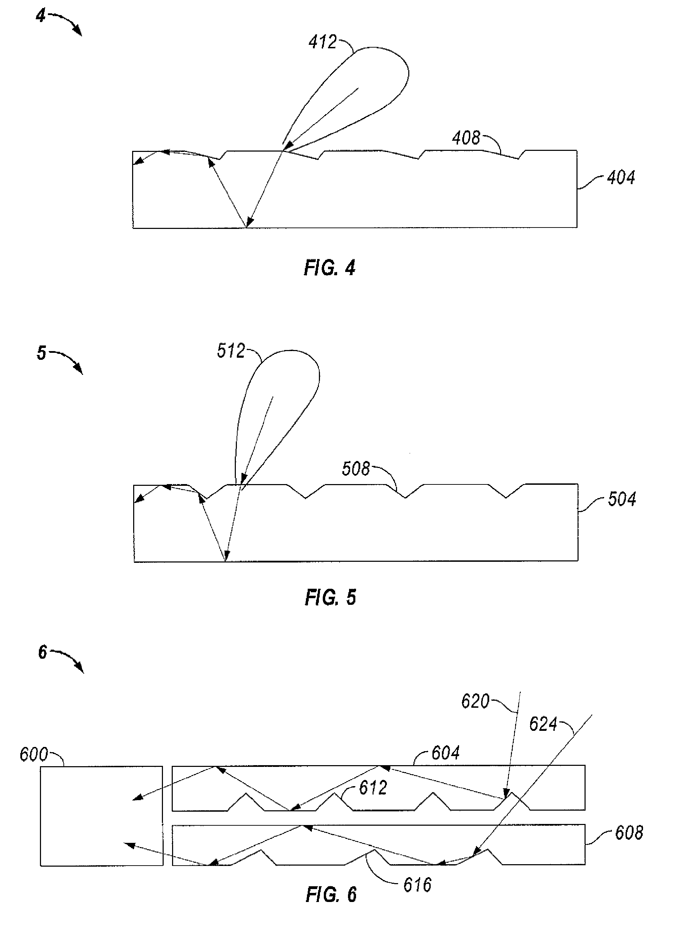

It is generally known that the physical properties of the prismatic features can be varied to alter the size, shape and angle of the incidence lobes. For example, **Figure 4** illustrates an embodiment comprising a light guide 404. Prismatic features 408 are disposed on the bottom surface of the light guide 404. Light incident on the upper surface of the light guide 404 is turned into the light guide 404 by the prismatic feature 408 and guided through the light guide 404 by TIR. The angular separation α between the facets comprising the prismatic feature 408 is large for example, greater than 90 degrees thereby resulting in wide prismatic features. The wide prismatic features can turn light incident at substantially grazing angles of incidence, for example, at approximately 5 degrees-45 degrees from the surface of the light guide 404.

By contrast, the embodiment shown in **Figure 5****,** the angular separation α between the facets of the prismatic features 508 is small for example, less than 90degrees, thereby resulting in narrow angled facets. The wide prismatic features can turn light incident at angles substantially close to the normal to the surface, for example, at approximately 5degrees-45 degrees from the normal to the surface of the light guide 504.

**Figure 6** shows an embodiment comprising of two light guides 604 and 608 disposed laterally with respect to an edge of a photo cell 600. Light guide 604 further comprises of relatively narrow prismatic features 612 and light guide 608 further comprises of relatively wide angled facets 616. Ray of light 620 close to the normal for example, at 5 degrees- 45 degrees from the normal to the surface of the two light guides 604 and 608 is efficiently collected and guided through light guide 604 with relatively narrow angled facets whereas the ray of light 624 incident at grazing angle for example, at approximately 5 degrees- 45 degrees to the surface of the two light guides 604 and 608 is efficiently collected and guided through the light guide 608 with relatively wider facets.

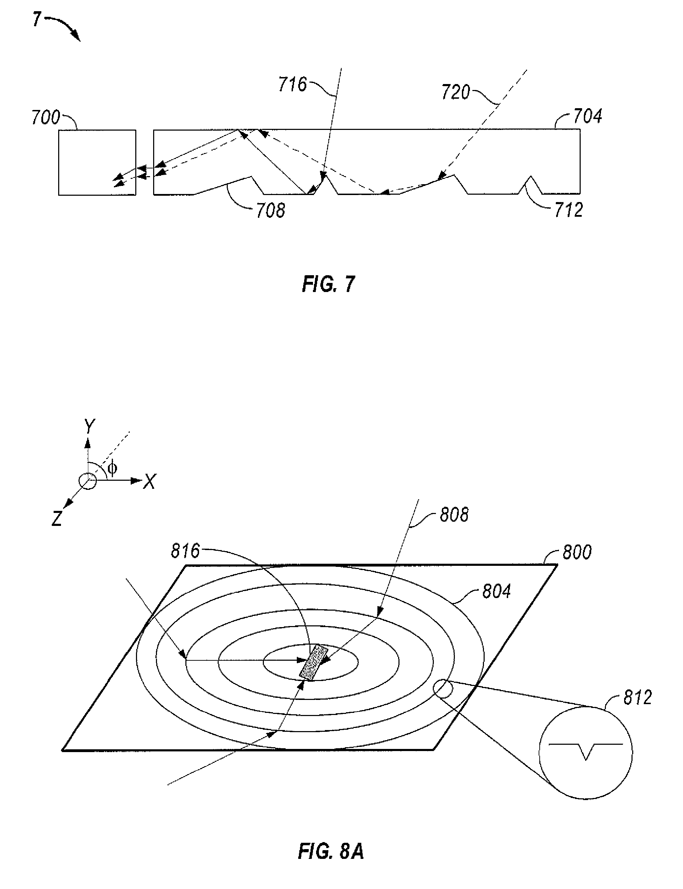

One advantage of this design is that light can be collected at a wide range of angles efficiently without mechanically rotating the film. Thus the dependence of the performance of the photo cell on the time of day and month of the year can be significantly reduced. For example, light from the sun may be incident on the light guide at grazing angles in morning and evening while the light from the sun may be incident on the light guide close to the normal around noon. The embodiment described above comprising multiple light guide layers with relatively narrow and wide angled facets will be able to collect light with approximately equal efficiency in the morning, afternoon and evening. **Figure 7** illustrates an alternate embodiment comprising both narrow and wide angled facets on the same light guide.

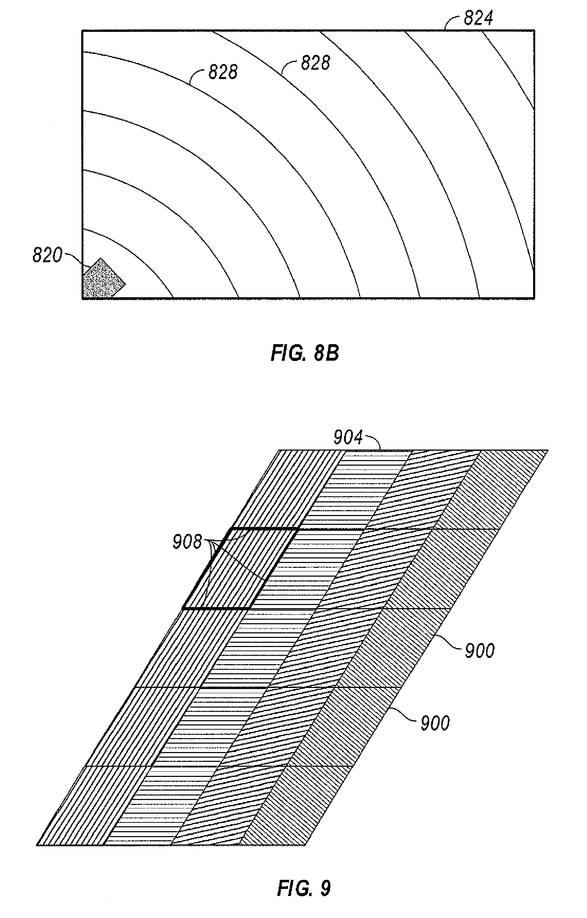

**Figure 8** illustrates an embodiment using a multi angle approach. In one embodiment, the elongated facets of the prismatic features or v grooves have non linear extent. The particular embodiment illustrated in embodiment comprises of a light guiding plate, sheet or film 800 formed from an optically transmissive material. Grooves are arranged along concentric circles 804 on the surface of the light guiding plate 800. In some embodiments, the grooves may be disposed along elliptical paths. These grooves may be v shaped grooves as indicated by the cross-section 812. V grooves that are concentric can be fabricated using a similar fabrication process as linear v grooves. Such a light guide will accept light at a wide range of angles Φ azimuthal to the plane of the light guide 800. The v grooves turn the light. Light then propagates to the center of the concentric pattern as indicated by light ray 808 and is incident on a photo cell 816 placed at the center of the concentric pattern. The embodiment described in **Figure 8** may be advantageous to collect diffused ambient light for example, in cloudy conditions.

In an alternate embodiment, as indicated in **Figure 8A****,** a photo cell 820 may be positioned at one corner of a light guiding plate, sheet or film 824. The light guiding plate, sheet or film may have rectangular, square or some other geometry. Grooves maybe formed on the light guiding plate, sheet or film along curves 828. The centers of the curves 824 are not at the center of the light guiding plate, sheet or film 824. The centers of the curves 828 are closer to the corner with the photo cell 820 than the other corner. The grooves are concave and they face the photo cell 820. The light guiding plate, sheet or film 824 comprising curved grooves 828 can collect light and turn it towards the concave side and direct the light to the photo cell 820. Such a design comprising curvilinear prismatic features or grooves may be more efficient in light collecting than the design comprising photo cells disposed along one edge of a linear prismatic film.

As described above, in some embodiments the length of the light guide may be limited to tens of inches to reduce loss due to reflections. However, limiting the length of the light guide may reduce the area over which light is collected. In some applications it may be advantageous to collect light over a large area. In such cases, one approach can be a matrix pattern of micro-structure shown in **Figure 9** may be beneficial. The embodiment shown in **Figure 9** illustrates a plurality of elements 900 arranged in a matrix pattern. The matrix pattern may comprise of a plurality of rows and columns. The number of rows can be equal to the number of columns. The number of elements in any two rows may be different. Similarly, the number of elements in any two columns may be different as well. In some embodiments, the matrix pattern may be irregular. Elements in the matrix comprise a light guiding plate, sheet or film with a plurality of v groove patterns 904 formed thereon. Other groove patterns besides v grooves can be used as well. Elements in the matrix may contain the same or different microstructure pattern. For example, the microstructure pattern in the different elements may vary in size, shape and type. Thus different elements in the matrix may collect sunlight at different angles. Photo cells 908 may be distributed within the periphery of the matrix as well as along the periphery of the matrix. The method disclosed above may be advantageous in fabricating large panels of light collectors coupled to photo cells for example, that can be fixed to roof tops of residential and commercial buildings.

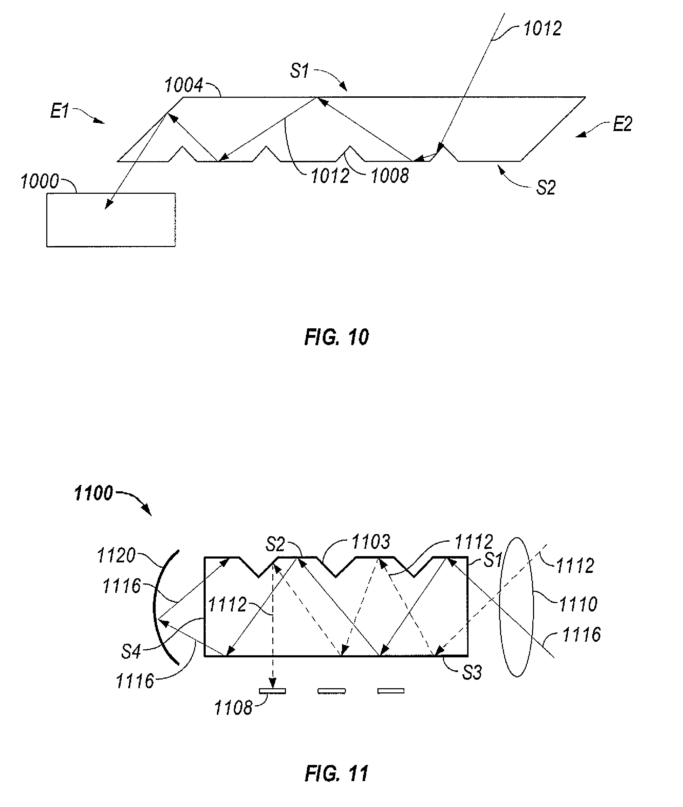

In the embodiments shown in **Figure 1A** the photo cell 100 is butted up against the edge of the light guiding plate, sheet or film 105. Instead it may be advantageous to bevel the light guiding plate, sheet or film at its edge so that light is redirected out of the light guiding plate, sheet or film towards a photo cell as shown in **Figure 10. Figure 10** illustrates an embodiment with a beveled light guiding plate, sheet or film 1004 comprising prismatic features 1008. The side view of the embodiment shown in **Figure 10** indicates a light guide with an upper surface S 1 and a lower surface S2. The upper and lower surfaces S 1 and S2 are bound on the left by an edge surface E1 and on the right by an edge surface E2. The edge surfaces E1 and E2 are inclined with respect to the upper and lower surfaces S1 and S2. The angle of inclination of the edge surfaces E1 and E2 with respect to upper and lower surfaces S1 and S2 is not equal to 90°. A ray of light 1012 is guided along the beveled light guide by total internal reflection and incident on a photo cell 1000 disposed rearward of the light guiding plate or film 1004. Beveling the edge of the light guiding plate, sheet or film 1004 may simplify the alignment between the photo cell 1000 and the light guiding plate, sheet or film 1004.

A ray of light 1012 incident on the upper surface of the light guiding plate, sheet or film 1004 is turned into the light guide 1004 by the prismatic feature 1008 and guided within the light guide 1004 by total internal reflection from the upper and lower surfaces S1 and S2. On striking the inclined edge E1, the guided light ray 1012 is directed out of the light guide close to the normal to the lower surface S2 towards a photo cell 1000 disposed rearward of the light guide 1004.

It is conceivable to arrange a plurality of beveled light guides comprising prismatic features in a matrix pattern similar to the embodiment described in **Figure 9**. The photocells in such an embodiment may be disposed underneath the matrix pattern. Ambient light incident on the upper surface of the matrix pattern is directed by the beveled edges of the light guides towards the photo cells disposed rearward of the matrix pattern.

In some embodiments it may be advantageous to collect light through the edge of the light guiding plate or film or a stack of light guiding plate or film comprising prismatic features as shown in **Figure 11. Figure 11** illustrates an embodiment comprising a light guiding plate, sheet or film 1100. The light guide comprises four surfaces S1, S2, S3 and S4. Light is collected through a collection lens 1104 and incident on one surface S 1 of the light guide 1100. Prismatic features 1103 disposed are disposed on an adjacent surface S2 of the light guide 1100. The light entering the light guiding plate, sheet or film 1100 is turned by prismatic features 1103 and guided by total internal reflection through the light guiding plate, sheet or film 1100. A ray of light indicated by 1112 is guided within the light guide 1100 by total internal reflection from the two surfaces S2 and S3 adjacent to the input surface S1 until it strikes one of the facets of the prismatic feature 1103. Upon striking the facet, the ray of light 1112 is directed out of the light guide 1100 towards the photo cell 1108 disposed away from the surface comprising the prismatic features 1103 as indicated in **Figure 11****.** However a ray of light indicated by 1116 which does not strike the prismatic feature and is thus not directed out of the light guiding plate, sheet or film 1100 is coupled back into the light guiding plate, sheet or film 1100 by a reflector 1120 at the other end away from the collection lens 1104.

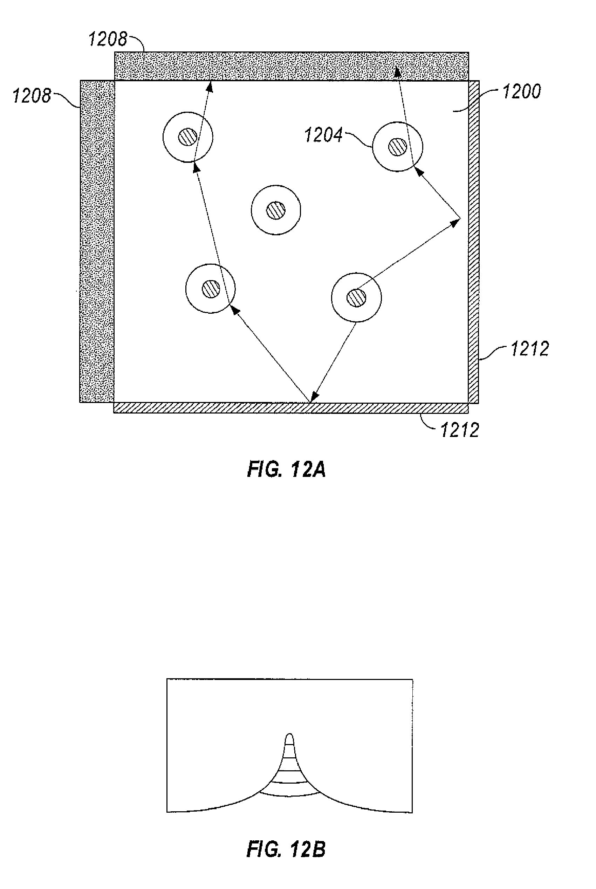

**Figure 12A** indicates the top view of a thin film solar concentrator 1200. The thin film solar concentrator 1200 is formed of an optically transmissive material and comprises two surfaces. The thin film solar concentrator has conical cavities 1204 formed on the surface of the thin film solar concentrator away from the surface through which light is incident instead of elongate grooves. **Figure 12B** indicates the side view of the thin film solar concentrator with the conical cavities. Referring again to **Figure 12A****,** the conical cavities 1204 are distributed throughout the light guiding thin film in a random or ordered manner. The thin film solar concentrator 1200 further comprises photo cells 1208 that are placed along two edges of the thin film solar concentrator 1200. In the embodiment illustrated in Figure 12A, reflectors 1212 are placed along the remaining edges of the thin film solar concentrator 1200 to increase light trapping efficiency. However, in alternate embodiments the reflectors 1212 may be replaced with photo cells 1208.

The conical cavities indicated in **Figure 12B** have a circular cross section. However, conical cavities with elliptical cross section may be formed as well. Light incident on the surface of the thin film solar concentrator 1200 is total internally reflected by the conical cavities 1204 and directed toward the photo cells 1208. The conical cavities are three dimensional structures and can thus accept light from a plurality of directions and reflect it along a plurality of directions. The embodiment described in **Figure 12A** and **Figure 12B** can collect light in a full solid angle and thus has greater light collecting capability.

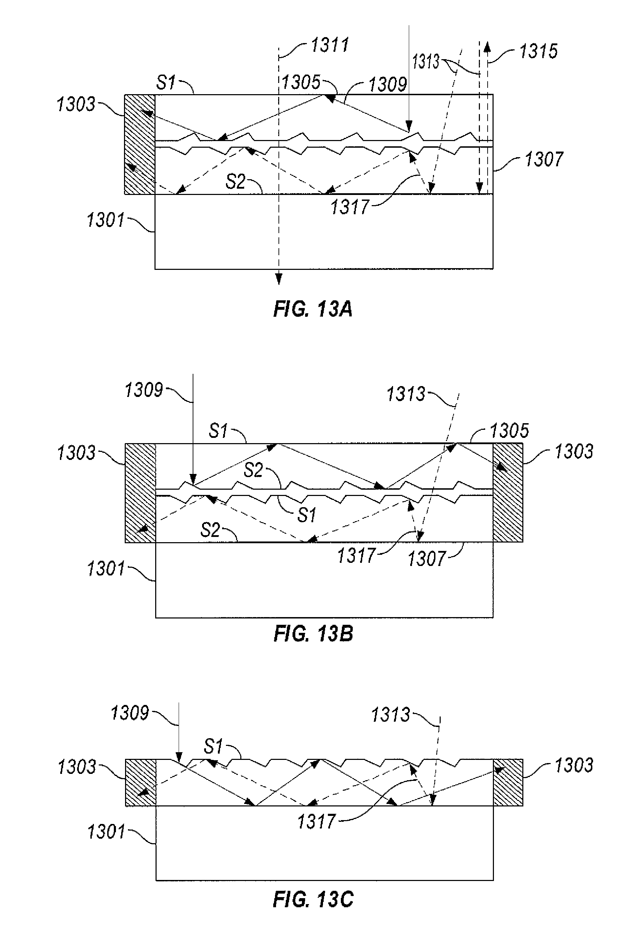

In some embodiments, two light guiding layers with prismatic features may be stacked to collect ambient and reflected light as shown in **Figures 13A-13C****.** The embodiment illustrated in **Figure 13A** comprises a top light guiding layer 1305 and a bottom light guiding layer 1307. (The terms top and bottom are only referred with respect to the drawings even though the structure can be reoriented.) The light guiding layers 1305 and 1307 comprise a top surface S1 and a bottom surface S2. The top light guiding layer 1305 further comprises prismatic features disposed on the bottom surface S2. The bottom light guiding layer 1307 comprises prismatic features disposed on the top surface S1. In some embodiments, the prismatic features on the two light guiding layers may be offset with respect to each other. In some embodiments, for example, wherein the two light guiding layers 1305 and 1307 are diffusive, the prismatic features may not be offset with respect to each other. In some embodiments, the offset distance between the prismatic features in the top light guiding layer 1305 and the bottom light guiding layer 1307 are configured to reduce or avoid visual artifacts. The two light guiding layers 1305 and 1307 may be joined together by adhesive. In some embodiments, the two light guiding layers 1305 and 1307 may be laminated together. In some embodiments, the two light guiding layers may comprise a gap there between.

The two light guiding layers 1305 and 1307 may be disposed on a substrate 1301. The substrate 1301 may be selected from a group consisting of a transparent substrate and may be a partially reflecting surface or other suitable material. In some embodiments, the substrate 1301 may comprise a smart glass or switchable glass. Smart glass or switchable glass is a glass or glazing that can change its degree of transparency in response to an applied voltage. Smart glass or switchable glass can comprise electro-chromic devices, suspended particle devices or polymer dispersed liquid crystal devices. In electro-chromic devices, the smart glass is formed of an electro-chromic material. In some embodiments a layer of electro-chromic material may be disposed on the outer or inner surface of a transparent medium. The electro-chromic material can change its transparency between opaque, translucent and transparent in response to an electric voltage or current. Once a change has been effected, the electro-chromic material will maintain its degree of transparency even after the electrical voltage or current is removed. In embodiments comprising smart glass formed with suspended particle devices, a thin layer of particles in the form of a laminate, film or sheet may be disposed between two layers of transparent material such as glass or plastic. When no electrical voltage is applied, the particles may be arranged in a random fashion and may absorb or obstruct passage of light. However in response to an applied voltage, the particles may be aligned and may allow light to pass through them. In polymer dispersed liquid crystal devices, a layer of liquid crystal material may be disposed between two transparent layers comprising glass or plastic. Similar to the suspended particle devices, when no electrical voltage is applied the liquid crystals may be oriented in a random fashion and thus obstruct light. In response to an electrical voltage, the liquid crystals may be oriented along a direction and allow light to pass through them. The two light guiding layers 1305 and 1307 may be affixed to the substrate 1301 by adhesive. In some embodiments, the two light guiding layers 1305 and 1307 may be laminated to the substrate 1301. This substrate 1301 may be diffusive in some embodiments. For example the substrate 1301 may have a diffusely reflective surface in certain embodiments.

A photocell 1303 is disposed to one side (e.g., either to the left or to the right as shown in Figure 13A or elsewhere) of the two light guiding layers 1305 and 1307. In Figure 13A, the photocell is disposed to the left of the light guiding layers 1305 and 1307. An incident beam of light 1313 that strikes a facet on the bottom surface S2 of the top light guiding layer 1305 is deflected by the facet and guided through the top light guiding layer 1305 toward the photocell 1303. Thus, the top light guiding layer 1305 can be used to capture a portion of the incident light. Some of the incident light may not strike a facet of the top light guiding layer 1305. Some of the incident light that does not strike a facet of the top light guiding layer 1305 may pass through the bottom light guiding layer 1307 and the substrate 1301 as indicated by ray 1311. Some of the incident light that does not strike a facet of the top light guiding layer 1305 (for e.g., ray 1313) may be reflected from the interface of the bottom light guiding layer 1307 and the substrate 1301 out of the top light guiding layer 1305 as indicated by the ray 1315. However some of the reflected light may strike a facet on the top surface of the bottom light guiding layer 1307 as indicated by ray 1317 and be guided through the bottom light guiding layer towards the photocell 1303. (As discussed above, the substrate 1301 may be diffusive, e.g., have a diffusely reflective surface. In some embodiments, a diffusing layer may be disposed on the substrate. Other designs can be used.) Thus the bottom light guiding layer 1307 may capture light that is not collected by the top light guiding layer 1305 and is reflected from the substrate 1301. Other configurations are also possible.

In some embodiments, the light collection ability of the light guiding layer can vary linearly with the density of the features. Thus to increase the amount of light captured by the two light guiding layers 1305 and 1307 and to decrease the amount of light exiting through the substrate or the top light guiding layer, the density of the prismatic features can be increased. In some embodiments, the surface area of the prismatic features can be approximately 5%-10% of the total surface area of the light guiding layer. In some embodiments, the density of features can be greater than 10% of the overall surface area of the film. Other configurations are possible.

In some embodiments, the PV cells can be disposed to both sides of the light guiding layers 1305 and 1307 as shown in **Figure 13B****.** In **Figure 13B****,** incident light 1309 is collected by the top light guiding layer 1305 and directed towards photocell 1303b disposed to the right of the light guiding layers. Additionally, the bottom light guiding layer 1307 collects light reflected from the substrate 1301 and directed this collected light towards photocell 1303a disposed to the left of the light guiding layers. As discussed above, the substrate 1301 may be diffusive, e.g., have a diffusely reflective surface. In some embodiments, a diffusing layer may be disposed on the substrate. Still other configurations are also possible.

In some embodiments, the top light guiding layer 1305 may be excluded as illustrated in **Figure 13C****.** In **Figure 13C****,** two photocells 1303a and 1303b are disposed to the left and right respectively of the light guiding layer 1307. Incident beam of light 1309 strikes a facet of the prismatic feature disposed on the top surface S1 of the light guiding layer 1307 is refracted by the prismatic feature and is guided through the light guiding layer 1307 towards photocell 1303b. A beam of light 1313 that does not strike a facet enters the light guiding layer 1307 and is reflected by the substrate 1301. As discussed above, the substrate 1301 may be diffusive, e.g., having a diffusely reflecting surface. In some embodiments, a diffusing layer may be disposed on the substrate. The reflected ray 1317 strikes a facet of the prismatic feature disposed on the top surface S1 of the light guiding layer 1307 and is guided through the light guiding layer towards photocell 1303a. In this manner a single light guiding layer can be used to collect both incident and reflected light. A wide variety of other configurations are also possible.

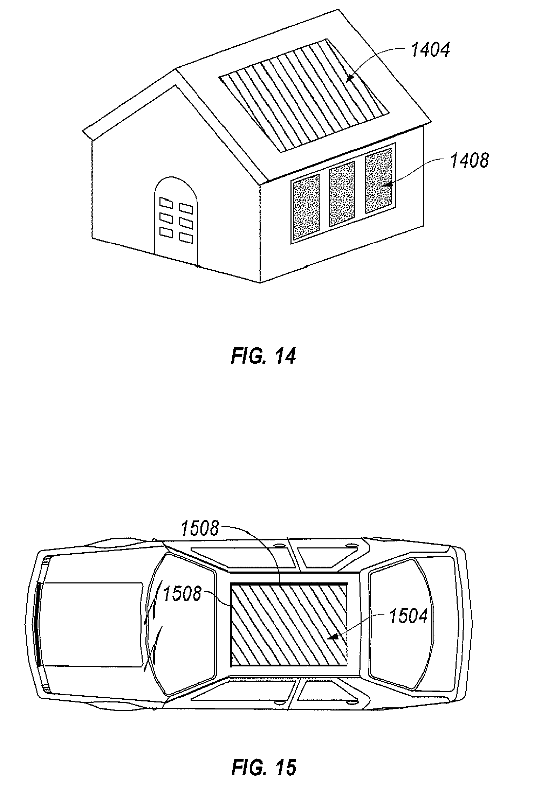

The method of using a light collecting plate, sheet or film comprising prismatic features to collect, concentrate and direct light to a photo cell can be used to realize solar cells that have increased efficiency and can be inexpensive, thin and lightweight. The solar cells comprising a light collecting plate, sheet or film coupled to a photo cell may be arranged to form panels of solar cells. Such panels of solar cells can be used in a variety of applications. For example, a panel of solar cell 1404 comprising a plurality of light collecting light guides optically coupled to photo cells may be mounted on the roof top of a residential dwelling or a commercial building or placed on doors and windows as illustrated in **Figure 14** to provide supplemental electrical power to the home or business. The light collecting plate, sheet or film may be formed of a transparent or semi-transparent plate, sheet or film. The prismatic light collecting plate, sheet or film may be colorized (for example red or brown) for aesthetic purposes. The light collecting plate, sheet or film may be rigid or flexible. In some embodiments, the light collecting plate, sheet or film may be sufficiently flexible to be rolled. Solar cell panels comprising of such sheets 1408 may be attached to window panes as shown in **Figure 14****.** The light collecting sheets may be transparent to see through the window. Alternatively they might be colorized to block light. In other embodiments, the prismatic sheets may have wavelength filtering properties to filter out the ultra-violet radiation.

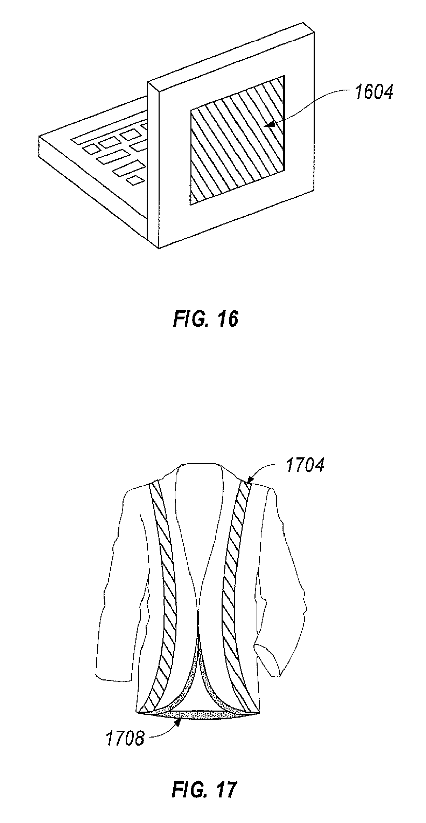

In other applications, light collecting plate, sheet or film may be mounted on cars and laptops as shown in **Figures 15** **and** **16** respectively to provide electrical power. In Figure 15 the light collecting plate, sheet or film 1504 is mounted to the roof of an automobile. Photo cells 1508 can be disposed along the edges of the light collector 1504. The electrical power generated by the photo cells can be used for example, to recharge the battery of a vehicle powered by gas, electricity or both or run electrical components as well. In **Figure 16**, the light collecting plate, sheet or film 1604 may be attached to the body (for example external casing) of a laptop. This is advantageous in providing electrical power to the laptop in the absence of electrical connection. Alternately, the light guiding collector optically coupled to photo cells may be used to recharge the laptop battery.

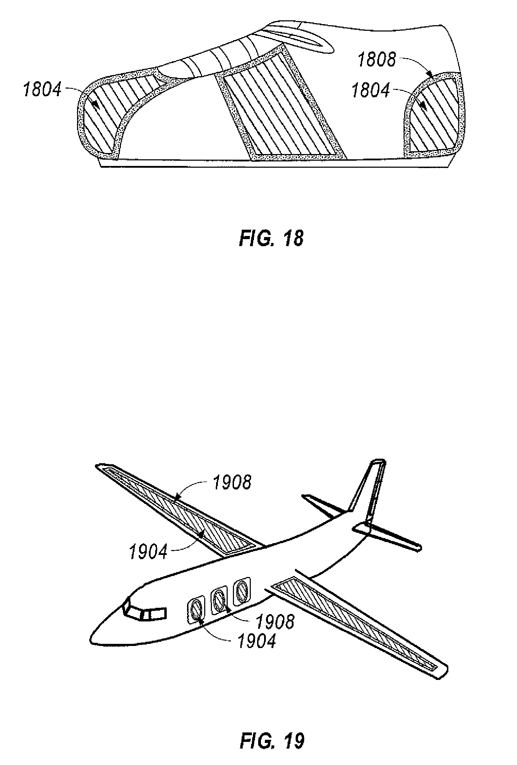

In alternate embodiments, the light collecting plate, sheet or film optically coupled to photo cells may be attached to articles of clothing or shoes. For example **Figure 17** illustrates a jacket or vest comprising the light collecting plate, sheet or film 1704 optically coupled to photo cells 1708 disposed around the lower periphery of the jacket or vest. In alternate embodiments, the photo cells 1708 may be disposed anywhere on the jacket or vest. The light collecting plate, sheet or film 1704 may collect, concentrate and direct ambient light to the photo cells 1708. The electricity generated by the photo cells 1708 may be used to power handheld devices such as PDAs, mp3 players, cell phone etc. Alternately, the electricity generated by the photo cells 1708 may be used to light the vests and jackets worn by airline ground crew, police, fire fighters and emergency workers in the dark to increase visibility. In another embodiment illustrated in **Figure 18****,** the light collecting plate, sheet or film 1804 may be disposed on a shoe. Photo cells 1808 may be disposed along the edges of the light collecting plate, sheet or film 1804.

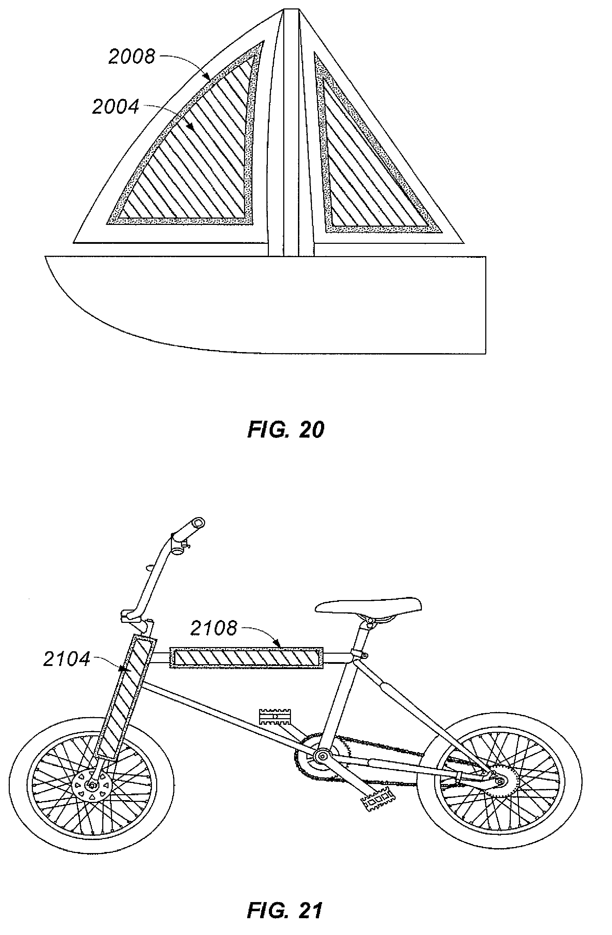

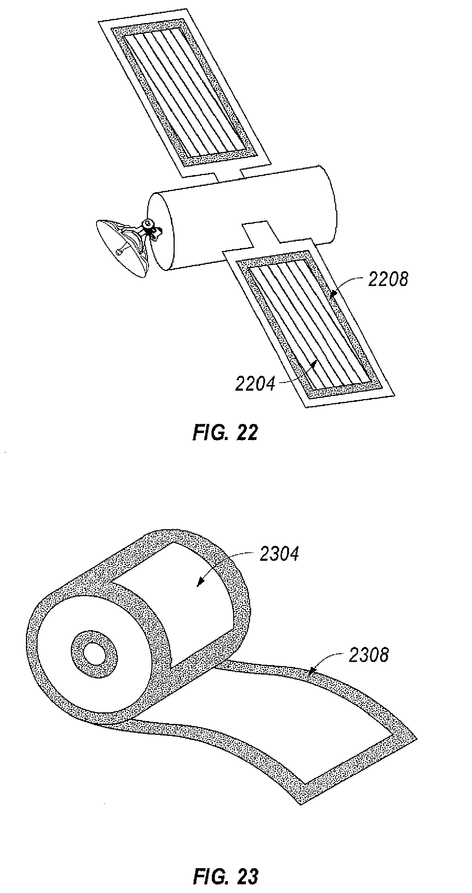

Panels of solar cells comprising of prismatic light collecting plate, sheet or film coupled to photo cells may be mounted on planes, trucks, trains, bicycles, sail boats and satellites as well. For example as shown in **Figure 19**, light collecting plate, sheet or film 1904 may be attached to the wings of an airplane or window panes of the airplane. Photo cells 1908 may be disposed along the edges of the light collecting plate, sheet or film as illustrated in **Figure 19**. The electricity generated may be used to provide power to parts of the aircraft. **Figure 20** illustrates the use of light collectors coupled to photo cells to power navigation instruments or devices in a boat for example, refrigerator, television and other electrical equipments. The light collecting plate, sheet or film 2004 is attached to the sail of a sail boat or alternately to the body of the boat. PV cells 2008 are disposed at the edges of the light collecting plate, sheet or film 2004. In alternate embodiments, the light collecting plate, sheet or film 2004 may be attached to the body of the sail boat for example, the cabin hole or deck. Light collecting plate, sheet or film 2104 may be mounted on bicycles as indicated in **Figure 21**. **Figure 22** illustrates yet another application of the light collecting plate, sheet or film optically coupled to photo cells to provide power to communication, weather and other types of satellites.

**Figure 23** illustrates a light collecting sheet 2304 that is sufficiently flexible to be rolled. The light collecting sheet is optically coupled to photo cells. The embodiment described in **Figure 23** may be rolled and carried on camping or backpacking trips to generate electrical power outdoors and in remote locations where electrical connection is sparse. Additionally, the light collecting plate, sheet or film that is optically coupled to photo cells may be attached to a wide variety of structures and products to provide electricity.

The light collecting plate, sheet or film optically coupled to photo cells may have an added advantage of being modular. For example, depending on the design, the photo cells may be configured to be selectively attachable to and detachable from the light collecting plate, sheet or film. Thus existing photo cells can be replaced periodically with newer and more efficient photo cells without having to replace the entire system. This ability to replace photo cells may reduce the cost of maintenance and upgrades substantially.

A wide variety of other variations are also possible. Films, layers, components, and/or elements may be added, removed, or rearranged. Additionally, processing steps may be added, removed, or reordered. Also, although the terms film and layer have been used herein, such terms as used herein include film stacks and multilayers. Such film stacks and multilayers may be adhered to other structures using adhesive or may be formed on other structures using deposition or in other manners.

The examples described above are merely exemplary and those skilled in the art may now make numerous uses of, and departures from, the above-described examples without departing from the inventive concepts disclosed herein. Various modifications to these examples may be readily apparent to those skilled in the art, and the generic principles defined herein may be applied to other examples, without departing from the spirit or scope of the novel aspects described herein. Thus, the scope of the disclosure is not intended to be limited to the examples shown herein but is to be accorded the widest scope consistent with the principles and novel features disclosed herein. The word "exemplary" is used exclusively herein to mean "serving as an example, instance, or illustration." Any example described herein as "exemplary" is not necessarily to be construed as preferred or advantageous over other examples.

## Claims

1. A device for collecting solar energy comprising:
a first means for guiding light, said first means having a first and second means for reflecting light such that light is guided within said first guiding means by multiple total internal reflections at said first and second light reflecting means;
a means for converting light energy into an alternate form of energy; and
a means for redirecting ambient light received through said first or second light reflecting means such that said light is guided in the first guiding means to said converting means.

2. The device of Claim 1, wherein said converting means comprises a photocell, or said first guiding means comprises a light guide, or said redirecting means comprises a plurality of prismatic features, or said first light reflecting means comprises a top surface of the first guiding means, or said second light reflecting means comprises a bottom surface of the first guiding means.

3. The device of any one of Claims 1 and 2, wherein said first guiding means further comprises a plurality of edges between said top surface and said bottom surface of said first guiding means, and wherein said converting means is disposed adjacent to one of said edges.

4. The device of Claim 1, wherein said first guiding means comprises a thin film.

5. The device of Claim 1, wherein said first guiding means comprises a polymer.

6. The device of Claim 1, wherein said redirecting means are shaped to redirect ambient light received at an angle between about 1 degree to 40 degrees with respect to a direction normal to said first guiding means such that received light is guided in said first guiding means by total internal reflection from said first and second light reflecting means to said converting means.

7. The device of Claim 1, wherein said redirecting means are shaped to redirect ambient light received at an angle between about 40 degree to 90 degrees with respect to a direction normal to said first guiding means such that received light is guided in said first guiding means by total internal reflection from said first and second light reflecting means to said converting means.

8. The device of Claim 1 further comprising a second means for guiding light, said second guiding means having a first and second means for reflecting light, said second guiding means comprising means for redirecting light incident on said second guiding means.

9. The device of Claim 1, wherein said converting means is disposed below said first guiding means.

10. The device of Claim 1, wherein said converting means is disposed at one corner of said first guiding means.

11. The device of Claim 1, wherein said first guiding means comprises a sheet.

12. The device of Claim 11, wherein said sheet comprises a plastic sheet.

13. The device of Claim 12, wherein said plastic sheet comprises acrylic or polycarbide.

14. The device of any one of Claims 1-12, wherein said sheet is at least 4 cm².

15. The device of Claim 1, wherein said first guiding means is flexible.

16. The device of Claim 1, wherein said converting means comprises a photovoltaic cell.

17. The device of Claim 1, wherein said converting means is butt coupled to an edge of said first guiding means.

18. The device of Claim 1, wherein said first guiding means includes a beveled surface and said first photocell is disposed with respect to said beveled surface to receive light reflected therefrom.

19. The device of Claim 1, wherein said redirecting means comprise elongate grooves.

20. The device of any one of Claims 1, 2, 6-8, and 19, wherein said elongate grooves are straight.

21. The device of any one of Claims 1, 2, 6-8, and 19, wherein said elongate grooves are curved.

22. The device of any one of Claims 1, 2, 6-8, and 19, wherein said redirecting means comprise planar facets angled with respect to each other.

23. The device of any one of Claims 1, 2, 6-8, and 19-22, wherein said planar facets are oriented at an angle of between 15 degrees to 85 degrees with respect to each other.

24. The device of Claim 1, wherein said redirecting means comprise pits.

25. The device of Claim 24, wherein said pits are conical.

26. The device of Claim 24, wherein said pits have at least three sides comprising tilted surface portions.

27. The device of Claim 1, wherein at least some of said redirecting means have different shapes.

28. The device of Claim 1, wherein said redirecting means are formed in a substrate.

29. The device of Claim 1, wherein said first guiding means further comprises a prismatic film disposed over a substrate and said prismatic film includes said redirecting means therein.

30. The device of Claim 1, wherein said redirecting means are disposed at said bottom surface of said first guiding means.

31. The device of Claim 1, wherein said redirecting means extend along a plurality of parallel linear paths.

32. The device of Claim 1, wherein said redirecting means extend along a plurality of concentric circular curved paths.

33. The device of Claim 1, wherein said redirecting means extend along a plurality of elliptical curved paths.

34. The device of Claim 1, wherein said first guiding means comprises:
a first section comprising said redirecting means, said redirecting means comprising a first set of prismatic features; and
a second section comprising a second set prismatic features,
wherein said first and second sections are disposed laterally with respect to each other and said prismatic features in said first section have a different shape or orientation than said prismatic features in said second section.

35. The device of Claim 34, wherein said first and second sections are part of an array of different sections of said first guiding means and a plurality of said different sections have prismatic features with shapes or orientations that are different from the shapes or orientations of prismatic features in said different sections.

36. The device of Claim 1, wherein said first guiding means is disposed on an automobile, aircraft, spacecraft, or nautical vessel.

37. The device of Claim 1, wherein said first guiding means is disposed on a bicycle, stroller, or trailer.

38. The device of Claim 1, wherein said first guiding means is disposed on an article of clothing.

39. The device of Claim 38, wherein said first guiding means is disposed on a shirt, pants, shorts, coat, jacket, vest, hat, or footwear.

40. The device of Claim 1, wherein said first guiding means is disposed on a computer, a cell phone, or a personal digital assistant.

41. The device of Claim 1, wherein said first guiding means is disposed on an architectural structure.

42. The device of Claim 44, wherein said first guiding means is disposed on a house or building.

43. The device of Claim 1, wherein said first guiding means is disposed on an electrical device.

44. The device of Claim 46, wherein said first guiding means is disposed on a light, phone, or motor.

45. The device of Claim 1, wherein said first guiding means is on a tent or a sleeping bag.

46. The device of Claim 1, wherein said first guiding means is rolled-up or folded.

47. A method of manufacturing a device for collecting solar energy, the method comprising:
providing a first light guide having top and bottom surfaces;
forming a plurality of prismatic features on one of said top or bottom surfaces said first light guide; and
disposing a photocell such that the first light guide is optically coupled to the photocell.

48. The method of Claim 47, further comprising forming said plurality of prismatic features by embossing.

49. The method of Claim 47, further comprising disposing said first light guide on a substrate.

50. The method of Claim 49 and, further comprising affixing said first light guide to the substrate using an adhesive.

51. The method of Claim 49, further comprising laminating said first light guide on the substrate.

52. The method of Claim 47-51, further comprising disposing a second light guide below said first light guide.

53. The method of Claim 52, further comprising forming a plurality of prismatic features on said second light guide.
